**Europäisches Patentamt**

**European Patent Office**

**Office européen des brevets**

(19)

(11) Veröffentlichungsnummer : **0 165 449 B2**

(12) **NEUE EUROPÄISCHE PATENTSCHRIFT**

(45) Veröffentlichungstag der neuen Patentschrift :
**19.02.92 Patentblatt 92/08**

(51) Int. Cl.⁵ : **C30B 15/06**

(21) Anmeldenummer : **85105795.0**

(22) Anmeldetag : **11.05.85**

(54) **Verfahren zur Herstellung von Halbleiterfolien.**

(30) Priorität : **23.05.84 DE 3419137**

(43) Veröffentlichungstag der Anmeldung :
**27.12.85 Patentblatt 85/52**

(45) Bekanntmachung des Hinweises auf die
Patenterteilung :
**17.08.88 Patentblatt 88/33**

(45) Bekanntmachung des Hinweises auf die
Entscheidung über den Einspruch :
**19.02.92 Patentblatt 92/08**

(84) Benannte Vertragsstaaten :
**BE DE FR GB IT NL**

(56) Entgegenhaltungen :
**EP-A- 0 072 565**
**DE-A- 2 817 285**

(56) Entgegenhaltungen :
**DE-A- 2 837 775**
**DE-A- 3 231 326**
**DE-A-28 508 05**
**DE-A-30 361 04**
**DE-A-32 312 68**
**US-A- 4 323 419**
**US-A-41 151 62**
**PATENTS ABSTRACTS OF JAPAN, Band 7, Nr.**
**86 (C-161)[1231], 9. April 1983; & JP - A - 58 15**
**096 (TOKYO SHIBAURA DENKI K.K.) 28-**
**01-1983**

(73) Patentinhaber : **BAYER AG**
**W-5090 Leverkusen 1 Bayerwerk (DE)**

(72) Erfinder : **Schwirtlich, Ingo, Dr.**
**St. Anton-Strasse 231**
**W-4150 Krefeld (DE)**
Erfinder : **Woditsch, Peter, Dr.**
**Deswatinesstrasse 83**
**W-4150 Krefeld (DE)**

EP 0 165 449 B2

**Beschreibung**

Die vorliegende Erfindung betrifft ein Verfahren zur Herstellung von Halbleiterfolien durch Erstarrung eines flüssigen Halbleiters auf einer horizontalen Unterlage.

Die Herstellung von Solarzellen erfolgt heute überwiegend aus Siliciumscheiben, die durch Zersägen von Einkristallen oder von gegossenen grobkristallinen Siliciumblöcken gewonnen werden.

Die Produktion der Kristalle und der nachfolgende Zerteilungsprozeß bilden dabei diskontinuierliche Verfahrensabläufe, die durch einen hohen Herstellungsaufwand und große Materialverluste gekennzeichnet sind. Insbesondere die Sägeverluste von größenordnungsmäßig 50% machen diese Lösung unwirtschaftlich.

Daher wurden in den letzten Jahren große Anstrengungen unternommen, wirtschaftlichere kontinuierlich arbeitende Verfahren zu finden, nach denen Siliciumbänder direkt aus der Schmelze hergestellt werden können.

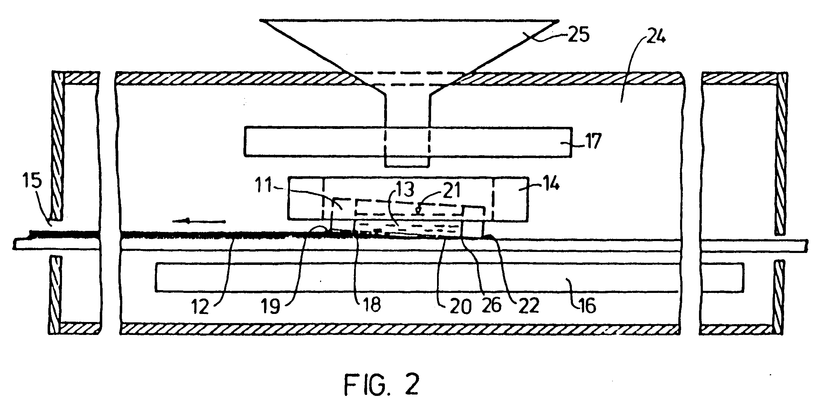

Aus der US-A 3 591 348 ist ein Verfahren bekannt, bei dem am oberen Ende eines in die Schmelze eingetauchten schlitzförmigen Formgebungsteils ein monokristallines Siliciumband erzeugt wird. Es läßt aber nur Erzeugungsgeschwindigkeiten im Bereich von 0,01-0,05 m/min zu. Dieser Wert ist für einen großtechnischen Produktionsprozeß zu gering, um die wirtschaftlichen Anforderungen erfüllen zu können. Deutlich höhere Erzeugungsraten lassen sich gemäß dem in der US-A 4 323 419 beschriebene Gießverfahren für Si-Folien erreichen, bei dem die Schmelze durch Extrudieren auf ein schnellaufendes Metallband aufgebracht wird. Die Kristallisation des Siliciums findet hierbei, wie auch insbesondere aus der Fig. 2 ersichtlich, nicht im Beschichtungsbereich zwischen der Austrittdüse und der Unterlage statt. Durch die schnelle Erstarrung der Schmelze bedingt, bildet sich hier jedoch nur ein mikrokristallines Gefüge aus, das aufgrund seiner hohen Korngrenzendichte die elektrischen Leistungsdaten einer daraus hergestellten Solarzelle beeinträchtigt. Dies gilt auch für das aus der DE-A 32 26 931 bekannte Verfahren, bei dem statt einer Metallfolie ein Netz als Trägersubstanz verwendet wird. Das aus Graphit- oder graphitierten Quarzfäden bestehende Netz wird über eine gekühlte Trommel transportiert und dabei aus der unteren Düsenöffnung einer Schmelzwanne mit schmelzflüssigem Silicium beschichtet. Bei diesem Verfahren ist das Netz im Anschluß an die Erstarrung fest in das Siliciumband integriert. Aufgrund von Wechselwirkungen des Netzes mit dem Silicium können Gitterfehler erzeugt werden, die die elektrischen Eigenschaften des Bandes verschlechtern können.

In den Anmeldungen derselben Anmelderin DE-A 32 31 266, DE-A 32 31 327 und DE-A 32 31 268 wird die Erstarrung der Si-Schmelze in den Maschen des Netzes vom eigentlichen Beschichtungsvorgang getrennt.

Gemäß der EP-A 72 565 wird das schmelzflüssige Silicium über eine schlitzförmige Öffnung auf ein steil nach oben transportiertes Substrat aufgetragen. Dieser in die Höhe orientierte Verfahrensablauf, der zudem eine gewisse Neigung von der Senkrechten erfordert, ist mit einem hohen Konstruktionsaufwand und Raumbedarf verbunden. Außerdem steht nur eine begrenzte Zeitspanne zur Verfügung, in der die Erstarrung des Siliciums erfolgen muß.

Darüber hinaus hat dieses Verfahren den Nachteil, daß bei sehr hohen Zuggeschwindigkeiten die Beschleunigungskräfte, die an einem Schmelzvolumenelement während des Beschichtungsvorganges angreifen, die Oberflächenspannung der Schmelze sowie die Adhäsionskräfte zwischen Schmelze und Substrat bzw. Schmelze und auf dem Substrat angebrachter Schlackenschicht übersteigen können. Das führt zu einem Abreißen des Schmelzfilmes.

Aus der DE-A 28 17 285 ist ein Verfahren zur Herstellung von Folien aus Schmelzen bekannt, bei dem die Kristallisation auf der Platte kurz hinter der Abstreifkante erfolgt.

Gemäß Patent Abstracts of Japan, Bd. 7, Nr. 86 (C-161), 9. April wird Siliciumschmelze durch eine schlitzförmige Öffnung gedrückt. Die Kristallisation findet außerhalb des Austrittspaltes auf einer Unterlage statt. Es besteht dabei keine Relativbewegung zwischen dem Formgebungskörper und der Unterlage.

Wesentlich für die Qualität der erzeugten Bänder und damit für ihre elektrischen Eigenschaften ist eine möglichst geringe Konzentration von Kristallfehlern wie Korngrenzen, Stapelfehler, Versetzung und Punktdefekte. Die Ausbildung dieser Gitterfehler wird wesentlich durch die Erstarrung, d. h. die Geschwindigkeit und Richtung der Grenzfläche zwischen der festen und flüssigen Phase beeinflußt. Die Aufgabe der vorliegenden Erfindung ist es, ein Verfahren zur Verfügung zu stellen, welches es ermöglicht, Halbleiterbänder aus der Schmelze bei hohen Geschwindigkeiten und somit wirtschaftlich zu erzeugen. Es sollen dabei große kolumnar gewachsene Kristallkörner mit einer geringen Fehlstellenkonzentration erhalten werden.

Überraschenderweise kann diese Aufgabe gelöst werden durch eine horizontale Arbeitsweise und die Ausbildung einer geometrisch vorgegebenen Phasengrenzfläche mit Hilfe eines Formkörpers. Dieser Formkörper dient dazu, die Siliciumschmelze auf ein sich bewegendes Trägermaterial aufzutragen. Gegenstand der Erfindung ist somit ein Verfahren zur Herstellung von Halbleiterfolien durch Erstarrung eines flüssigen Halbleiters auf einer Unterlage, das dadurch gekennzeichnet ist, daß der flüssige Halbleiter mit Hilfe eines Formkörpers auf die plattenförmige horizontale oder bis zu ± 30° gegen die Horizontale geneigte Unterlage aufgebracht wird,

2

wobei parallel in Längsrichtung zwischen der Unterlage und dem Formkörper eine Relativbewegung eingestellt wird und daß im Beschichtungsbereich zwischen dem Formkörper und der Unterlage ein Temperaturgradient so eingestellt wird, daß in diesem Bereich die Kristallisation einsetzt, wobei die geschwindigkeit der Relativbewegung 1 bis 20 m/min betreigt und daß bei einer Wanddicke b des Formkörpers die Länge a des Formkörpers bei einem Verhältnis $V_Z/V_K$ der zuggeschwindigkeit $V_Z$ zur Kristallisationsgeschwindigkeit $V_K$ und einer Foliendicke d durch die Beziehung

$$a = \frac{V_Z \cdot d}{V_K} + b$$

bestimmt wird.

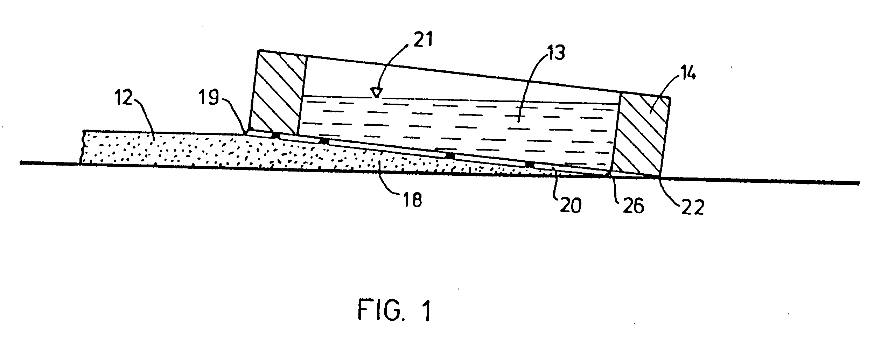

Die Abmessungen des Formkörpers bestimmen die Größe der Grenzfläche zwischen der flüssigen und der bereits erstarrten Phase, wie aus Fig. 1 zu entnehmen ist. Beim erfindungsgemäßen Verfahren steht aufgrund der Größe dieser Grenzfläche entschieden mehr Zeit für das Dickenwachstum der Folie zur Verfügung als bei anderen schnellen Ziehverfahren.

Beim erfindungsgemäßen horizontalen Folienziehen kann somit durch eine Vergrößerung der effektive Lange des Formkörpers der Wachstumskeil verlängert werden.

Dies wiederum erlaubt Kristallisationsgeschwindigkeiten, die um mehr als den Faktor 100 bei unvermindert hohen Zuggeschwindigkeiten niedriger liegen.

Dieses äußerst ökonomische Verfahren kann beispielsweise in der in Fig. 2 dargestellten Vorrichtung durchgeführt werden.

Diese besteht aus einem Formkörper (11), in den die Halbleiterschmelze (13) durch einen Trichter (25) eingefüllt wird. Der Formkörper (11) wird in einem Rahmen (14) gehalten, der eine freie vertikale Bewegung sowie geringe Kippbewegungen des Formkörpers zuläßt. Seine Bewegungsfreiheit wird nach unten durch das Substrat (12) bzw. durch den festen Halbleiter (18) des Wachstumskeils begrenzt. Am Austritt des verfestigten Halbleiters aus dem Formkörper bildet sich ein kleiner Meniskus (19) aus. Der Formkörper (11) schwimmt demnach an seiner in Zugrichtung vorne liegenden Kante auf einem Flüssigkeitsfilm (20) oberhalb des Wachstumskeils (18). Das in Zugrichtung hintere Ende des Formkörpers (11) liegt in Punkt (22) auf der Unterlage (12) auf. Im Anfangsbereich des Wachstumskeils (18) bildet sich ein weiterer Meniskus (26) aus, so daß ein Auslaufen des Siliciums verhindert wird.

Die am unteren Rand des Formkörpers herrschenden Druckverhältnisse können durch sein spezifisches Gewicht sowie sein Volumen zusammen mit der Schmelzhöhe (21) kontrolliert werden. Die auftretenden Kräfte in der Schmelze dürfen die Oberflächenspannung nicht überschreiten, wenn ein Auslaufen am unteren Rand des Formkörpers verhindert werden soll.

In einer vorteilhaften Ausführung des erfindungsgemäßen Verfahrens können die Temperatur des Formkörpers und der Unterlage geregelt werden.

Oberhalb des in Fig. 2 dargestellten Formkörpers (11) und der Halterung (14) befindet sich eine Heizung (17), die dazu dient, das geschmolzene Halbleitermaterial im Formkörper flüssig zu halten. Die Heizung (17) kann selbstverständlich auch als Ringheizung im oberen Bereich der Halterung (14) bzw. des Formkörpers ausgebildet sein. Die Heizung (16) dient dazu, die Temperatur der Unterlage (12) einzustellen.

Beim Kontakt des schmelzflüssigen Halbleitermaterials mit dem Trägermaterial wird sich unter der Voraussetzung, daß die Temperatur des Substrates unter dem Schmelzpunkt des Halbleiters liegt, eine dünne Schicht aus erstarrtem Halbleitermaterial ausbilden. Diese Schicht wird durch Wärmeabfuhr von der Unterseite der Unterlage während der Bewegung unter dem Formkörper hinweg weiterwachsen, solange der Kontakt zur flüssigen Phase besteht. Im dynamischen Gleichgewicht bildet sich dabei ein Wachstumskeil aus, dessen Länge mit der effektiven Länge des Formkörpers übereinstimmt.

Dieser Wachstumsprozeß wird dadurch positiv beeinflußt, daß zwischen dem Formkörper und der Unterlage ein Temperaturgradient eingestellt wird. Besonders vorteilhaft ist es dabei, daß an der in Zugrichtung befindlichen Seite des Formkörpers ein schwächerer Temperaturgradient eingestellt wird als auf der gegenüberliegenden Seite.

Selbstverständlich sind auch andere Formkörper zur Folienherstellung geeignet, wie beispielsweise ein starr angebrachter Körper mit einer der Filmstärke entsprechenden Öffnung an der Seite der Ziehrichtung.

Für das erfindungsgemäße Verfahren ist es unerheblich, ob das Substrat (12) unter dem Formkörper (11) oder der Formkörper über das Substrat hinweggezogen wird. Des weiteren muß diese Relativbewegung nicht auf die horizontale Ebene beschränkt sein. Es ist dann noch vorteilhaft durchführbar, wenn die Unterlage bis zu ±30° gegen die Horizontale geneigt ist. Der Maximalwinkel wird durch das Verhältnis von hydrostatischem Druck zur Oberflächenspannung der Schmelze an der Unterkante des Formkörpers sowie durch seine Benetzbarkeit, die Zugrichtung und die Relativgeschwindigkeit von Formkörper zur Unterlage bestimmt.

Das erfindungsgemäße Verfahren ist allgemein auf Halbleiter anwendbar, bevorzugt ist die Ausführungs-

EP 0 165 449 B2

form, in der der Halbleiter Silicium ist. Dieses kann in beliebiger Reinheit eingesetzt werden, natürlich kann auch dotiertes Material eingesetzt werden.

Es ist auch möglich gemäß dem erfindungsgemäßen Verfahren Mehrfachfolien herzustellen, wobei man jeweils eine neue Schicht auf eine bereits hergestellte Folie aufbringt, somit die fertige Folie als Unterlage einsetzt. Diese Mehrfachfolien können durch Einsatz unterschiedlich dotierter Halbleiter auch Schichten unterschiedlicher Dotierung aufweisen. Die Breite der nach dem Verfahren hergestellten Folien ist nur durch die Breite des Formkörpers begrenzt.

Die beim erfindungsgemäßen Verfahren verwendeten Materialien unterliegen keiner Beschränkung, soweit sie unter den einzustellenden Bedingungen nicht vom Halbleiter angegriffen werden. Als Unterlage können beispielsweise Platten aus Graphit unterschiedlicher Dichte bzw. einer Dichte von mehr als 1,75 g/cm$^3$ verwendet werden. Weitere Verbesserungen sind durch eine geeignete Beschichtung beispielsweise mit Si-Nitriden oder Si-Carbiden möglich, wobei es durch Kombination dieser Verbindungsklassen dem Fachmann möglich ist, die Benetzungverhältnisse so einzustellen, daß optimale Folienoberflächen entstehen. Die Verhaftung der Folien und das Benetzen des Substrates lassen sich dabei in Übereinstimmung bringen, so daß sich einerseits glatte Oberflächen ausbilden, andererseits auch eine Trennung der Folie vom Substrat einfach erfolgt. Weitere Trägerplatten aus Silliciumcarbid und Siliciumnitrid sind ebenso geeignet wie oxidische Keramiken, wobei durch niedrige Temperaturen des Substrates von 800-1 200 °C oder durch Beschichten eine Wechselwirkung zwischen dem Trägermaterial und dem flüssigen Halbleiter weitgehend verhindert werden kann. Die oben diskutierten Beschichtungs verfahren sind auch bei diesen Substraten zu verwenden.

Der Formkörper kann aus Si-Carbid, Si-Nitridöder Graphit bestehen, sofern diese Materialien von flüssigem Halbleiter nicht zerstört werden, d. h. nicht nur keinem chemischen Angriff unterliegen sondern auch nicht mechanisch zerstört werden. Beschichtung auf den Formkörpern lassen sich ebenso einsetzen wie eine Imprägnierung mit flüssigen und anschließend pyrolisierbaren Materialien.

Bevorzugt ist somit eine Verfahrensvariante, gemäß der Formkörper und/oder die Unterlage aus hochdichtem Graphit Si$_3$N$_4$, SiC-beschichtetem Graphit, Keramik oder Silicium besteht.

Die folgenden Beispiele sollen das erfindungsgemäße Verfahren verdeutlichen, ohne eine Einschränkung des Erfindungsgedankens darzustellen.


Beispiel 1


Als Formkörper zum Auftragen des Siliciums auf das Trägermaterial diente ein Graphitrahmen (11) mit einer lichten Weite von 50 mm x 40 mm bei einer Höhe von 15 mm. Die Wandstärke betrug 10 mm. Dieser Körper lag direkt auf einer Graphitplatte (12) auf, die als Substrat diente. Durch einen weiteren Graphitrahmen (14) wurde der Formkörper (11) so gehalten, daß seine Bewegungsfähigkeit auf ein Ausweichen nach oben beschränkt wurde. Der Rahmen (14) war gleichzeitig als Verbindungselement der beiden Seitenwände (24) ausgelegt. Unterhalb der Substratplatte (12) sowie oberhalb des Rahmens (14) war jeweils eine großflächige Widerstandsheizung (16, 17) angebracht. Sie regelten die Wärmezufuhr zur Siliciumschmelze (13) und zur Trägerplatte (12). Das Silicium wurde in einem außerhalb angeordneten Kipptiegel aufgeschmolzen, der wie bereits erwähnt, nicht eingezeichnet wurde, und durch den Quarztrichter (25) sowie eine öffnung in Heizung (17) in den auf 1380-1420 °C vorgeheizten Formkörper (11) eingefüllt. Gleichzeitig wurde das Trägermaterial (12) mit einer Geschwindigkeit von 1,2 m/min unter dem Formkörper hindurchgezogen. Bei einer Temperatur des Substrates von 1 000-1 200 °C bildete sich ein Band aus erstarrtem Silicium von ca. 50 mm Breite, daß sich während des nachfolgenden Abkühlprozesses selbständig von der Substratplatte löste, so daß es nach dem Erkalten abgenommen werden konnte. Die Dicke des Bandes betrug ca. 0,5 mm bei einer aufbaubedingten Länge von ca. 150 mm.


Beispiel 2


Es wurde entsprechend Beispiel 1 verfahren, wobei ein Rahmen (14) aus Si-Nitrid und als Trägermaterial eine Substratplatte aus Si-Carbid, die mit Siliciumnitrid/oxid beschichtet worden war, eingesetzt wurde. Bei einer Substratlänge von ca. 500 mm wurde ein Film von 0,4 mm Dicke aus Si erzeugt, der sich ohne Schwierigkeiten vom Trägermaterial lösen ließ. Der gebildete Siliciumfilm hatte eine Länge von 300 mm.


**Patentansprüche**

1. Verfahren zur Herstellung von Halbleiterfolien durch Erstarrung eines flüssigen Halbleiters auf einer Unterlage, dadurch gekennzeichnet, daß der flüssige Halbleiter mit Hilfe eines Formkörpers auf die plattenför-

<div align="center">4</div>

EP 0 165 449 B2

mige horizontale oder bis zu ± 30° gegen die Horizontale geneigte Unterlage aufgebracht wird, wobei parallel in Längsrichtung zwischen der Unterlage und dem Formkörper eine Relativbewegung eingestellt wird und daß im Beschichtungsbereich zwischen dem Formkörper und der Unterlage ein Temperaturgradient so eingestellt wird, daß in diesem Bereich die Kristallisation einsetzt, wobei die Geschwindigkeit der Relativbewegung von 1 bis 20 m/min betragt, und daß bei einer Wanddicke b des Formkörmers die Länge a des Formkörpers bei einem Verhältnis $V_Z/V_K$ der Zuggeschwindigkeit $V_Z$ zur Kristallisationsgeschwindigkeit $V_K$ und einer Foliendicke d durch die Beziehung

$$a = \frac{V_Z \cdot d}{V_K} + b$$

bestimmt wird.

2. Verfahren gemäß Anspruch 1, dadurch gekennzeichnet, daß der Formkörper vertikal beweglich ist.

3. Verfahren gemäß einem der Ansprüche 1 bis 2, dadurch gekennzeichnet, daß die Temperatur des Formkörpers und der Unterlage geregelt werden können.

4. Verfahren gemäß einem der Ansprüche 1 bis 3, dadurch gekennzeichnet, daß an der in Zugrichtung befindlichen Seite des Formkörpers ein schwächerer Temperaturgradient eingestellt wird als auf der gegenüberliegenden Seite.

5. Verfahren gemäß einem der Ansprüche 1 bis 4, dadurch gekennzeichnet, daß der Halbleiter Silicium ist.

6. Verfahren gemäß einem oder mehrerer der Ansprüche 1 bis 5, dadurch gekennzeichnet, daß der Formkörper und/oder die Unterlage aus hochdichtem Graphit, $Si_3N_4$, SiC-beschichtetem Graphit, Keramik oder Silicium besteht.

**Claims**

1. Process for the preparation of semiconductor films by solidification of a liquid semiconductor on a support, characterised in that the liquid semiconductor is applied by means of a shaping body to the plate shaped support which is placed horizontally or inclined to the horizontal by up to ±30°, a parallel relative movement being established in the longitudinal direction between the support and the shaping body and in that a temperature gradient is adjusted in the coating region between the shaping body and the support so that crystallisation sets in in this region, the speed of the relative displacement being from 1 to 20 m/min, and in that when the wall thickness of the shaping body is b and the ratio of the speed of pull $V_Z$ to the speed of crystallisation $V_K$ is $V_Z/V_K$ and the thickness of the film is d, the length a of the shaping body is determined by the equation

$$a = \frac{V_Z \cdot d}{V_K} + b$$

2. Process according to Claim 1, characterised in that the shaping body is vertically displaceable.

3. Process according to one of the Claims 1 to 2, characterised in that the temperature of the shaping body and of the support can be regulated.

4. Process according to one of the Claims 1 to 3, characterised in that the temperature gradient on the side of the shaping body in the direction of pull is adjusted to be flatter than on the opposite side.

5. Process according to one of the Claims 1 to 4, characterised in that the semi-conductor is silicon.

6. Process according to one or more of Claims 1 to 5, characterised in that the shaping body and/or the support consists of high density graphite, $Si_3N_4$, SiC-coated graphite, ceramics or silicon.

**Revendications**

1. Procédé de production de feuilles de semiconducteur par solidification d'un semiconducteur liquide sur un substrat, caractérisé en ce que le semiconducteur liquide est appliqué à l'aide d'un corps de formage sur le substrat de forme plate, horizontal ou incliné jusqu'à ± 30° par rapport à l'horizontale, un mouvement relatif s'établissant alors parallèlement, dans la direction longitudinale, entre le substrat et le corps de formage, en ce qu'on règle dans l'intervalle de revêtement entre le corps de formage et le substrat un gradient de température choisi de manière que la cristallisation s'effectue dans cet intervalle, la vitesse du mouvement relatif étant de 1 à 20 m/min, et en ce que pour une épaisseur de paroi b du corps de formage, la longueur a de ce corps, pour un rapport $V_Z/V_K$ de la vitesse de traction $V_Z$ à la vitesse de cristallisation $V_K$ et pour une épaisseur de feuille d, est déterminée par la relation

$$a = \frac{V_Z \cdot d}{V_K} + b$$

2. Procédé suivant la revendication 1, caractérisé en ce que le corps de formage est mobile verticalement.

3. Procédé suivant l'une des revendications 1 et 2, caractérisé en ce que la température du corps de formage et celle du substrat peuvent être réglées.

4. Procédé suivant l'une des revendications 1 à 3, caractérisé en ce qu'on établit, du côté du corps de formage se trouvant dans la direction de traction, un gradient de température plus faible que sur le côté opposé.

5. Procédé suivant l'une des revendications 1 à 4, caractérisé en ce que le semiconducteur est du silicium.

6. Procédé suivant une ou plusieurs des revendications 1 à 5, caractérisé en ce que le corps de formage et/ou le substrat sont constitués en graphite à haute densité, en $Si_3N_4$, en graphite revêtu de SiC, en céramique ou en silicium.

FIG. 1

FIG. 2